# EUROPEAN PATENT SPECIFICATION

(11) **EP 0 410 288 B1**
(45) Date of publication and mention of the grant of the patent: **22.05.1996**
(21) Application number: 90113758.8
(22) Date of filing: 18.07.1990
(51) Int. Cl.: H01L 21/82, H01L 27/108

(54) **Dynamic random access memory cells and methods for fabrication**
Dynamische Speicherzelle mit wahlfreiem Zugriff und Herstellungsverfahren
Cellule de mémoire dynamic à accès aléatoire et procédés de fabrication

(30) Priority: 25.07.1989 US 385341; 25.07.1989 US 385601; 25.07.1989 US 385328; 25.07.1989 US 385344; 25.07.1989 US 385340
(43) Date of publication of application: 30.01.1991
(60) Divisional application: 95117190.9
(73) Proprietor: TEXAS INSTRUMENTS INCORPORATED, Dallas Texas 75265 (US)
(72) Inventor: Shen, Bing-Whey, Richardson, Texas 75080 (US); McKee, Randy, Plano, Texas 75075 (US); Chung, Gishi, Garland Texas 75044 (US); Shirai, Kiyoshi, Dallas, Texas 75252 (US); Teng, Clarence, Plano, Texas 75093 (US); Coleman, Donald J., Jr., Plano, Texas 75094 (US); Yashiro, Masaaki, Plano, Texas 75080 (US)
(74) Representative: Leiser, Gottfried, Dipl.-Ing.

(56) References cited:
- EP-A- 0 169 346
- US-A- 4 734 384
- US-A- 4 918 502

## Description

### FIELD OF THE INVENTION

The present invention relates to the field of integrated circuit design and fabrication. More specifically, the present invention relates to the field of dynamic random access memory arrays, cells and other structures and the methods for fabricating those structures.

### BACKGROUND OF THE INVENTION

The quest to develop smaller and smaller dynamic random access memory (DRAM) cells and related structures is a well-known goal. In integrated circuit manufacturing, certain costs are relatively fixed no matter what integrated circuit is fabricated. Thus, the greater density of memory on a single integrated circuit provides greater economy on a per bit basis by spreading these fixed costs across more memory capacity. In addition, greater memory storage capacity allows greater memory capacity of the end user products, such as computers, in a smaller package. Therefore, the value to the customer is increased. Because 50% or more of the area of a DRAM is used for memory cells themselves, reduction of the memory cell size allows for far greater numbers of those memory cells to be placed on the DRAM.

Several techniques have been developed to try to reduce the size of memory cells. For example, the fundamental dynamic random access memory cell has been reduced to a minimum of components, i.e. a transistor and a capacitor connected to the source of the transistor. The transistor allows access to the charge stored on the capacitor and the stored charge represents data. The first step in reducing the size of DRAM cells was the effective integration of the transfer transistor and the capacitor. An example of this is found in Kuo, "Random Access Memory Cell with Different Capacitor and Transistor Oxide Thickness", U.S. Patent No. 4,240,092, issued December 16, 1980 and assigned to the assignee of this application. Kuo is an example of a "Hy-C" cell. As the density of DRAMs increased, limitations of the Hy-C cell became apparent. In order to provide accurate data storage and retrieval, the capacitance of the storage capacitor must be as large as possible. However, the capacitance of the storage capacitor is directly proportional to the area between the plates of the capacitor. In a planar capacitor cell, like the Hy-C cell, this creates a fundamental tradeoff between cell size and cell capacitance.

In order to minimize the surface area occupied by the memory cell while maintaining adequate storage capacitor capacitance, vertical capacitor structures were developed. An example of such a structure is found in Sunami, "Cell Structures for Featured DRAMs", International Electron Devices Meeting Technical Digest (1985), Paper 29.1, pages 694-697. In some cases, the capacitor is formed on a trench etched into the surface of the substrate. An example of this can be found in Ishiuchi, et al., "Submicron CMOS Technologies for 4Megabit Dynamic RAM", International Electron Devices Meeting Technical Digest (1985), Paper 29.4, pages 706-709. In other cases, a stacked or multiple plate concept providing a vertically stacked capacitor was investigated. An example of this can be found in Sunami, et al., supra.

The difficulties of forming the storage capacitor in a trench have introduced a great deal of complexity into the fabrication of the DRAM cells. For example, see Baglee, et al., U.S. Patent No. 4,721,987, "Trench Capacitor Process for High Density Dynamic RAM", issued January 26, 1988 and assigned to the assignee of this application. Although the storage capacitor itself has been made smaller, the additional difficulties in connecting the transfer transistor to the capacitor have introduced requirements for spacing tolerances and increased complexity in leakage components. These have all necessitated complex processing steps and additional area occupied to fabricate the DRAM cells.

### Summary of the Invention

According to the present invention there is provided a method of forming a coupled capacitor and transistor as defined in claim 1.

### Description of the drawings

The present invention is best understood with regard to the following described embodiments read in conjunction with the drawings provided herewith wherein:
Figure 1 is a side view schematic diagram of a dynamic random access memory cell which is one embodiment of the present invention;
Figure 2 is an electrical schematic diagram showing the electrical operation of the DRAM cell shown in Figure 1;
Figures 3A through 3M are schematic diagrams showing the processing steps necessary to fabricate the DRAM cell shown in Figure 1, where all but Figure 3I are side view schematic diagrams and Figure 3I is a plan view schematic diagram;
Figure 4 is a schematic plan view diagram of a memory array including the DRAM cell described with regard to Figure 1;
Figure 5 is a side view schematic diagram of a DRAM cell with a planar storage capacitor which is not part of the present invention;
Figure 6 is an electrical schematic diagram showing the electrical characteristics of the DRAM cell shown in Figure 5; and
Figure 7 is a plan view diagram showing the layout of the cell shown in Figure 5.

### Detailed Description

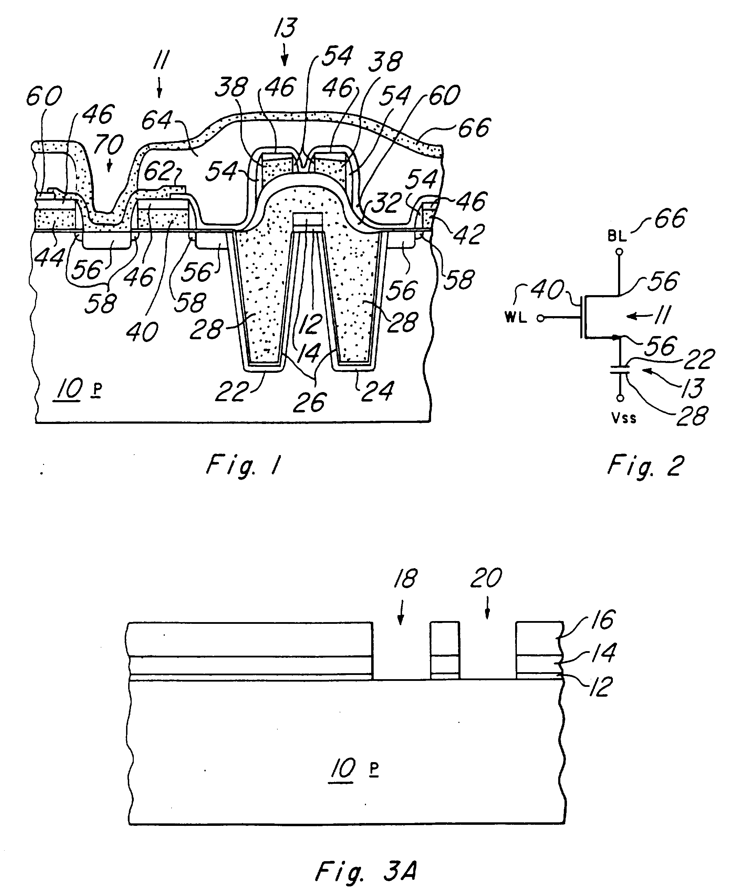

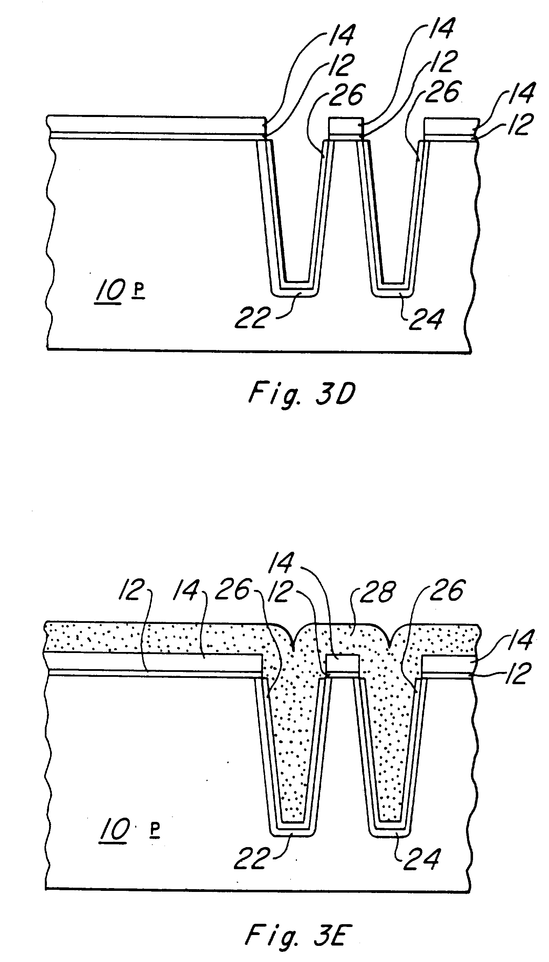

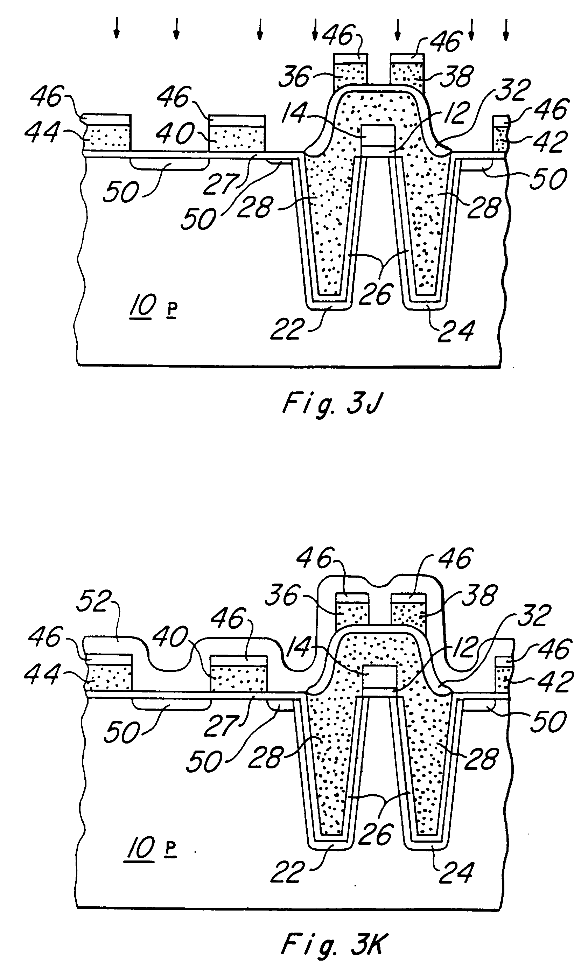

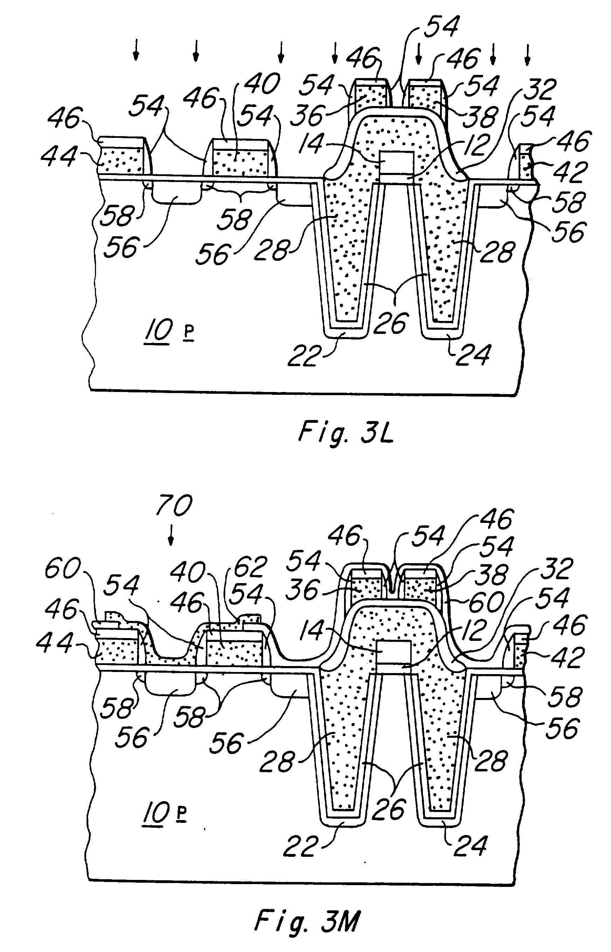

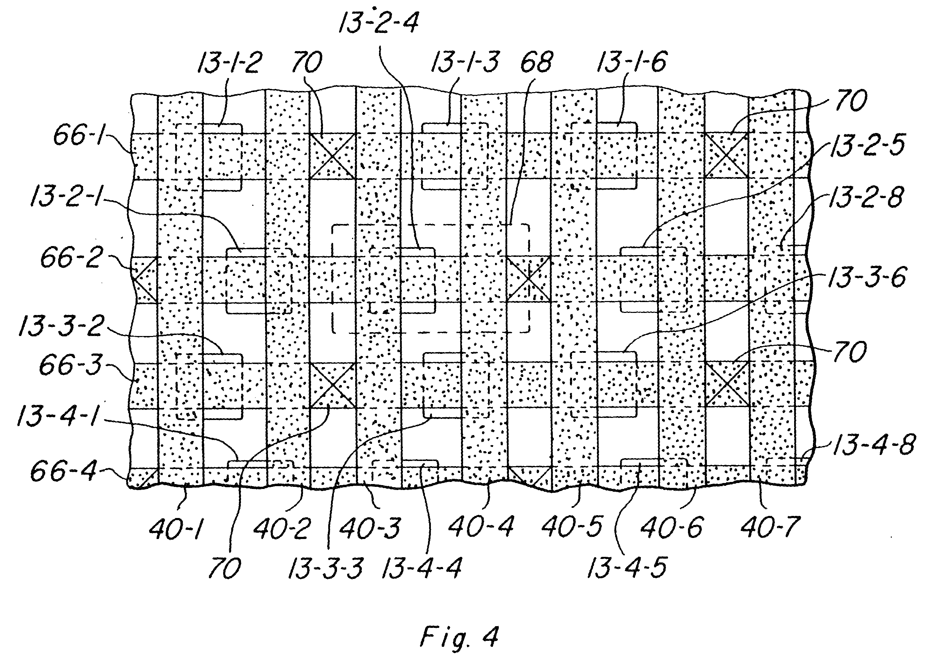

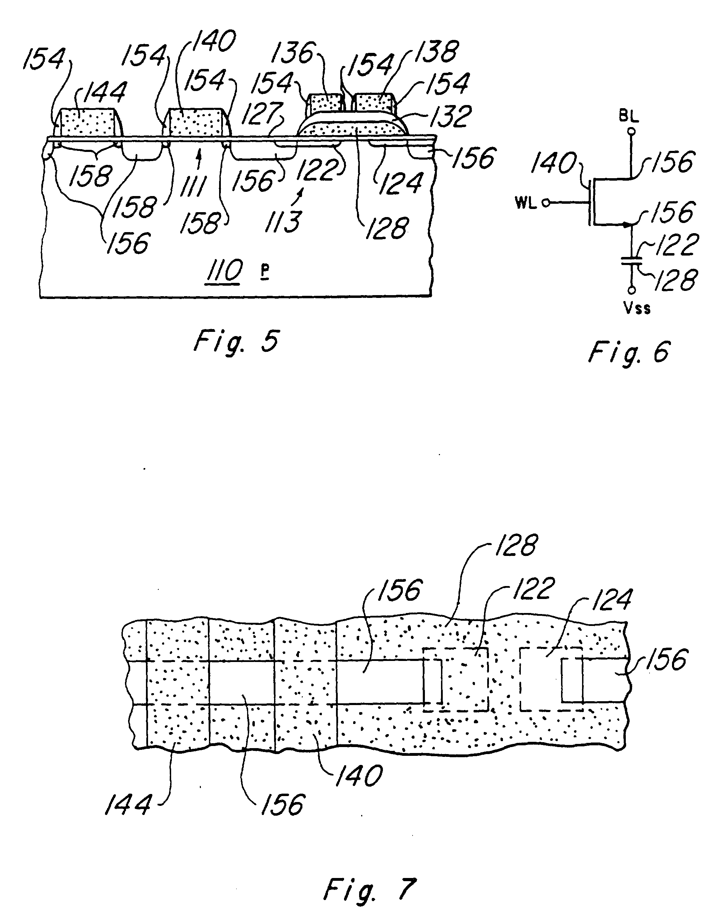

Figure 1 is a side view schematic diagram showing one embodiment of the present invention which is a DRAM cell. Figure 2 is an electrical schematic diagram showing the electrical operation of components of the embodiment shown in Figure 1, with correspondingly numbered components in Figure 2 corresponding to those components in Figure 1. Figures 3A through 3M are schematic diagrams showing the processing steps for fabricating the embodiment shown in Figure 1. Figure 4 is a memory array including the memory cell shown in Figure 1. Figure 5 is a side view schematic diagram of another method using amplified manufacturing steps as explained with regard to Figures 3A through 3M but including a planar capacitor. Figure 6 is an electrical schematic diagram showing the electrical operation of the embodiment shown in Figure 5. Figure 7 is a plan view diagram showing the layout of components of the embodiment shown in Figure 5.

Figure 1 is a side view schematic diagram of one embodiment of the present innovation. The memory cell of Figure 1 consists of a transfer transistor 11 and a storage capacitor 13. When data is to be stored on the memory cell, the data is placed on bitline 66 and high voltage signal (approximately 3.3. volts) is placed on gate 40. Thus, the voltage placed on bitline 66 is passed through via source 56 to storage node 22. Capacitor 13 is comprised o storage diffusion 22 in capacitive coupling with field plate 28. Field plate 28 is tied to a reference potential and thus a charge representing the voltage applied by bitline 66 is stored on storage diffusion 22. To store the data on storage diffusion 22, the positive voltage is removed from gate 40 thus stopping continuity between source/drain regions 56. Gate 40 is part of a word line extending perpendicular to the page of Figure 1. Gate 44 controls access to a storage capacitor off to the left hand side of the page. Wordlines 36 and 38 pass over field plate 28 to provide control for memory cells extending perpendicularly into the page and out from the page. Partial wordline 42 controls access to the capacitor formed by field plate 28 and storage diffusion 24.

Figure 2 is an electrical schematic diagram showing the electrical operation of transfer transistor 11 in capacitor 13 of Figure 1. The reference numerals of Figure 2 correspond to the reference numerals of Figure 1 and indicate the electrical functions of the reference components.

Figures 3A through 3M are schematic diagrams showing the processing steps for forming the embodiment shown in Figure 1. P substrate 10 is a crystalline silicon substrate doped to a P-type conductivity of approximately 0.9 ohms-centimeters. P substrate 10 may be a complete substrate of 0.9 per ohm centimeter material or a 0.9 ohm centimeter epitaxial layer may be formed on the surface of a substrate having a differing doping type or concentration. Silicon dioxide layer 12 is formed by thermal oxidation of P substrate 10 to a thickness of approximately 350 Angstroms (1 Angstrom = 10⁻¹⁰ m) by thermal oxidation in an oxygen ambient in approximately 950°C for approximately 50 minutes. Silicon nitride layer 14 is formed by low pressure chemical vapor deposition to a thickness of approximately 1000 Angstroms. A hardmask 16 is formed to a thickness of approximately 5000 Angstroms by chemical vapor deposition of phosphorous doped silicon dioxide. A layer of photoresist (not shown) is then patterned and silicon dioxide layer 12, silicon nitride layer 14 and silicon dioxide layer 16 are etched to provide openings 18 and 20 as shown in Figure 3A.

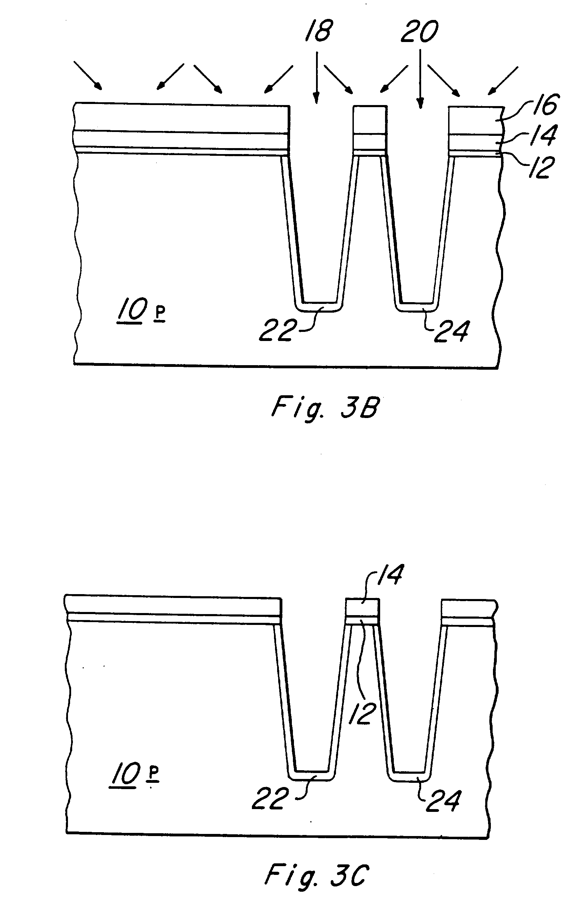

Using silicon dioxide layer 16 as a mask, trenches 18 and 20 are etched into the surface of substrate 10 as shown in Figure 3B. A suitable etching method can be found in Douglas, "Trench Etch Process for a Single-Wafer RIE Dry Etch Reactor", U.S. Patent No. 4,784,720, issued November 15, 1988 and assigned to the assignee of this application. The walls of trenches 18 and 20 are then doped using arsenic to a doping concentration of approximately 3 × 10¹⁹ dopant atoms per centimeter³ using one of many processes. For example, an angled ion implantation with arsenic ions at an angle of 8° while rotating substrate 10 may be performed. The ions are implanted at an energy of approximately 100 kiloelectron volts in a density of approximately 5 × 10¹⁵ ions per centimeter. Other suitable doping techniques such as deposition of doped materials and diffusion of the dopants into substrate 10 may suitably be used.

Silicon dioxide layer 16 is then removed using wet etching in a 10% buffered hydrofluoric acid solution for approximately 40 seconds. The resulting structure is shown in Figure 3C.

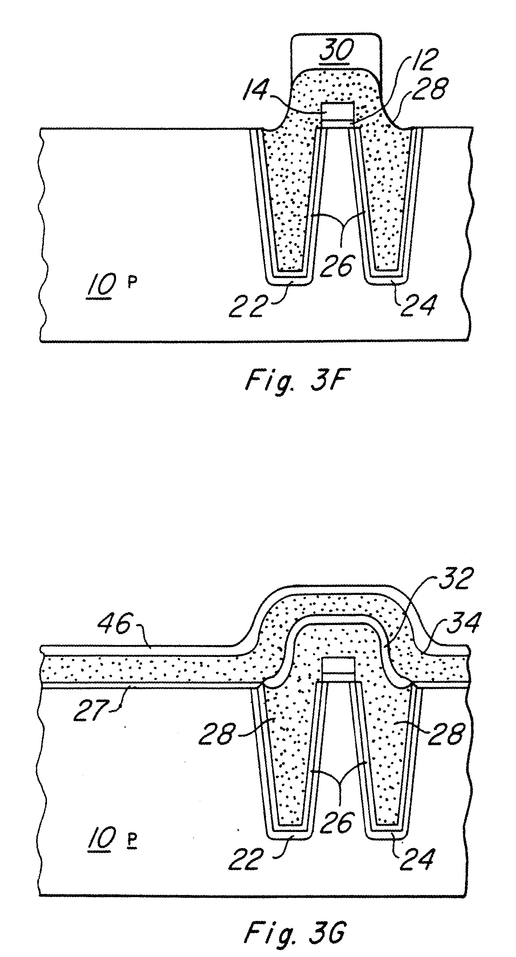

A suitable capacitor dielectric 26 such as thermally grown silicon dioxide is then formed to a thickness of approximately 60 Angstroms using thermal oxidation in an oxygen ambient for approximately 40 minutes at a temperature of approximately 850°C. Other suitable dielectrics include silicon dioxide, silicon nitride, silicon dioxide stacks, oxidized silicon nitride and other deposited materials such as tantalum oxide. A layer of polycrystalline silicon 28 is then deposited by low pressure chemical vapor deposition of silane to a thickness of approximately 5000 Angstroms. The resulting structure is shown in Figure 3E. Polycrystalline silicon layer 28 is doped by in situ doping to provide a conductivity of approximately 0.005 ohm-centimeters. Polycrystalline silicon layer 28 may then be thinned on the surface to a thickness of approximately 2,000 Angtroms using wet etching or plasma etching in a carbon tetraflouride plasma. This reduces the topology of polycrystalline silicon layer 28. Polycrystalline silicon layer 28 provides a field plate which covers all areas of the array excepting where the transfer transistors are to be formed. Field plate 28 provides an implantation mask for formation of those transistors thus providing a self-aligned system for aligning field plate 28 and the transfer transistors. This provides a greater packing density because no alignment tolerance is required between the transfer transistors and the field isolation device. A layer of photoresist 30 is formed on the surface of field plate 28 and field plate 28 is etched using a combination isotropic and anisotropic process. An anisotropic etch is used such as hydrofluoric/bromic acid for approximately 1 minute. An isotropic etch is then performed to provide sloped sidewalls to leave the structure as shown in Figure 3F.

Photoresist layer 30 is then removed using standard photoresist removal processes such as wet removal or ashing. Silicon nitride layer 14 and silicon dioxide layer 12 are then removed by etching in a plasma of *C*₂*F*₆/*CHF*₃*.* The structure of Figure 3F with photoresist layer 30 thus removed is then subjected to an oxidation step in a oxygen/steam ambient for approximately 30 minutes to form silicon dioxide layers 27 and 32 as shown in Figure 3G. Because of the higher rate of oxidation of polycrystalline silicon layer 28, silicon dioxide layer 32 is much thicker than silicon dioxide layer 27. The use of an overall oxidation step provides a contiguous isolation layer from the moat surface of substrate 10 to field plate 28. Thus complete sealing of field plate 28 from subsequent conductive layers is achieved. In another embodiment, the surface of the moat is protected by silicon nitride layer 14 and silicon dioxide layer 12 while polycrystalline silicon layer 28 is oxidized. Silicon dioxide layer 27 is then formed in a separate oxidation step. A polycrystalline silicon layer 34 and a silicon dioxide layer 46 are then deposited on the surface of the structure of Figure 3G as shown in Figure 3G. Polycrystalline silicon layer is approximately 2500 Angstroms thick. Silicon dioxide layer 46 is approximately 1,000 Angstroms thick. Polycrystalline silicon layer 34 has a conductivity of approximately 0.005 ohms-centimeter.

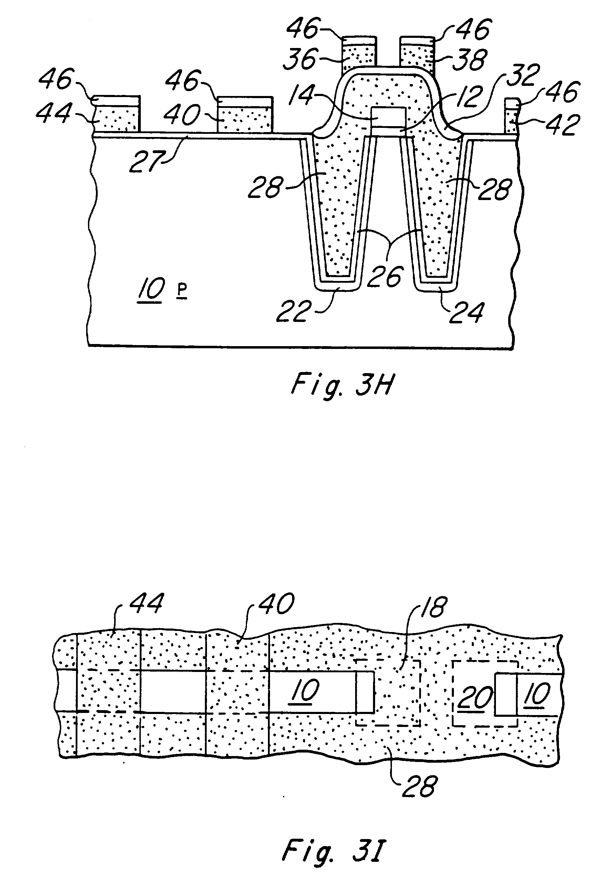

Polycrystalline silicon layer 34 and silicon dioxide layer 46 are then patterned and etched to provide wordlines 36, 38, 40, 42 and 44 as shown in Figure 3H.

Figure 3I is a plan view of a portion of the structure of Figure 3H. As can be seen from Figure 3I, exposed moat regions of substrate 10 (covered by silicon dioxide layer 27) are left where field plate 28 and wordlines 40 and 44 do not cover substrate 10. Field plate 28 and the wordlines provide an implantation mask for the formation of source drains which provides an automatic alignment between the gates provided by the wordlines 40 and 44, and filed plate 28. Because of this automatic alignment, no additional alignment tolerance is required to form the source/drains of the transfer transistor 11 (fig. 1) and an additional masking step its potential for yield loss is avoided. The capacitor structures in Figure 31 are indicated by trenches 18 and 20 although, of course, the capacitors are actually the more complex structures shown in Figure 3H.

The structure of Figure 3H is subjected to an ion implantation of phosphorous ions having an energy of approximately 60 kiloelectron volts and a density of approximately 4 x 10¹³ ions per cm to form lightly doped source/drain regions 56 as shown in Figure 3J. A layer of silicon nitride 52 is then deposited by low pressure chemical vapor deposition to a thickness of approximately 1000 Angstroms on the structure of Figure 3J as shown in Figure 3K. Silicon nitride layer 52 is then etched anisotropically using a sulphur hexaflouride etchant in reactive ion etching to provide sidewall nitride layers 54 as shown in Figure 3L. Because the reactive ion etching step which formed sidewall nitride layers 54 is selective to silicon dioxide, silicon dioxide layers 46 and 26 protect wordlines 36, 38, 40, 42 and 44 and substrate 10, respectively. Prevention of this damage caused by ion bombardment protects the conductivity of the wordlines and the source/drain regions formed in substrate 10.

The structure of Figure 3L is subjected to ion implantation of arsenic ions having an energy of approximately 100 kiloelectron volts and a density of approximately 3 x 10¹⁵ ions per cm to form source/drain regions 56 as shown in Figure 3L. The remaining portions of lightly doped source/drain regions 50 (Figure 3K) provide lightly doped drain regions 58 as shown in Figure 3L. Lightly doped drain regions 58 reduce the filed density at the edges of transfer transistor 11 thus reducing the incidence of hot electrons in the operation of transistor 11 and increasing the lifetime of transistor 11. In another embodiment, source/drain regions 56 may be omitted. Because of the close spacing of DRAM cells, the high conductivity of source/drain 56 is not critical, therefore, they may be omitted.

Silicon dioxide layer 60 is formed by chemical vapor deposition to a thickness of approximately 200 Angstroms. A photoresist pattern (not shown) is then formed on the surface of the structure of Figure 3M to provide an opening for bitline contact to source/drain region 56 between gates 40 and 44. Silicon dioxide layer 60 is then subjected to reactive ion etching using an etchant elective to silicon dioxide such as carbon tetraflouride to provide opening 70. This opening is used for the deposition of thin polycrystalline silicon layer 62 which has a thickness of approximately 300 Angstroms and a conductivity of approximately 0.005 ohm-centimeters. Polycrystalline silicon layer 62 is then patterned using common lithographic techniques to provide the structures shown in Figure 3M. Polycrystalline silicon layer 62 provides a "landing pad" for deposition of bitline 66. Because polycrystalline silicon layer 62 extends up onto silicon dioxide layer 60, a much larger alignment tolerance area for positioning of the contact to source/drain 56 is available.

Boron-phosphorous doped silicon dioxide layer 64 is deposited to a thickness of approximately 5,000 Angstroms on the surface of the structure of Figure 1. A photoresist pattern (not shown) is then formed to allow the formation of opening 70 as shown in Figure 1. Silicon dioxide layer 64 is then etched using an etchant such as carbon tetraflouride which is selective to silicon dioxide to provide an opening to the top surface of polycrystalline silicon layer 62. Because polycrystalline silicon layer 62 extends up wider than the opening between wordlines 40 and 44, no alignment tolerance between wordlines 44 and 40 is necessary thus the distance between wordlines 40 and 44 may be the minimum lithography dimension allowed by the lithography system used. Bitline 66 is then deposited on the surface of silicon dioxide 64. Of course, standard via formation may be used to contact diffusion 56, but this increases the array size. Bitline 66 may be any suitable conductive material such as polycrystalline silicon, tungsten, titanium tungsten or others. In the embodiment where diffusion 56 is omitted, a highly doped contact region is formed in the contact by diffusion of dopants from polycrystalline silicon layer 62.

Figure 4 is a plan view of an array of the DRAM cells shown in Figure 1. Each of the wordlines is designated 40-1 through 40-7 and each of the bitlines is designated 60-1 through 60-4. Capacitors are labeled 13-X-Y. The X designates the bitline which is connected through the pass transistor to the capacitor. The Y designates the wordline which controls the conductivity of the transistor connected to the capacitor. Contact points 70 are designated. For example, on memory cell 68 which has capacitor 13-2-4, the signal on wordline 40-4 controls access to the capacitor and the signal on bitline 66-2 is stored on capacitor 13-2-4 when a high voltage signal is placed on wordline 40-4.

Because of the structure of capacitor 13-2-4, wordline 40-4 is not critically aligned to capacitor 13-2-4. Because the moat region is allowed to extend up onto capacitor 13-2-4 and because storage diffusion 22 provides a source/drain region if wordline 40-4 extends onto capacitor 13-2-4, no alignment tolerance is required between capacitor 13-2-4 and wordline 40-4. However, because it is desirable to have the operation of the lightly doped drain between capacitor 13-2-4 and wordline 40-4, a spacing of approximately 0.1 micron for the thickness of storage diffusion 22 and an additional thickness of 2 alignment tolerances (approximately 0.1 micron) is patterned between capacitor 13-2-4 and wordline 40-4.

Although Figure 4 shows capacitors 13-X-Y as square openings, it has been determined that it is best to provide rounded contours for the openings for the capacitors. With rounded corners, intracapacitor high electric fields can be avoided and closer spacing between capacitors 13-X-Y may be utilized successfully. In addition, an additional implant of boron ions along with the angled ion implantation shown in Figure 3B provides an envelope of heavily doped P type region around storage diffusion 22. This provides an even greater margin of leakage prevention and allows even denser packing between capacitor 13-X-Y. Previous common knowledge had indicated that the minimum spacing between diffused storage node trench capacitors was about 1 micron. This was caused by the track-off between high substrate doping to prevent leakage and low substrate doping for high breakdown voltage level. Computer synthesis has shown that a density as close as 0.5 microns may be utilized with the field plate scheme as shown in this embodiment. The layout of Figure 4 provides a minimum spacing between capacitors of approximately 0.8 microns. Given alignment tolerances and 0.6 micron lithography techniques, a minimum spacing of 0.6 microns would then be achieved. Data indicates that this would be acceptable and a cell size of 1.5 x 2.6 microns may be achieved.

Although the structure of Figure 1 uses a trench capacitor cell, the field plate structure shown in Figure 1 may successfully be utilized with the planar cell as shown in Figure 5. Field plate 128 corresponds to field plate 28 shown in Figure 1. Rather than depositing polycrystalline silicon into a trench, field plate 128 is formed on the surface of substrate 110 over storage diffusions 122 which are formed by patterned ion implantation. The remaining structures shown in Figure 5 correspond to the numerically indicated structures with the addition of 100 shown in Figure 1 and are formed using the same techniques. Thus, the self-aligned features of the bitline contact and the moat region to the field plate region are achieved using a planar capacitor.

Figure 6 is an electrical schematic diagram showing the electrical operation of the memory cell shown in Figure 5.

Figure 7 shows the plan view of selected structures of the memory cell of Figure 5 which correspond to the layout structure of Figure 31. Thus, the self-aligned structure in manufacturing techniques are not limited to the use of trench capacitors and may be successfully used with other storage capacitor techniques and other circuit structures. For example, a stacked capacitor structure may be formed extending from the source region adjacent to capacitor 122 onto the surface of wordline 140 and field plate 128.

Although specific embodiments of the present invention are herein described, they are not to be construed as limiting the scope of the present invention. Other embodiments will become clear to those skilled in the art in light of the teachings of this specification. For example, although the embodiments show the use of crystalline silicon, other semiconductor materials such as gallium arsenide may be used. In addition, although the manufacturing techniques used herein are described with regard to the fabrication of DRAM cells, the techniques used herein may have wide applicability in other integrated circuit structures. For example, formation of self aligned transistors to field plate isolation systems may have wide applicability in other device structures. The present invention is only limited by the claims appended hereto.

## Claims

1. A method of forming a coupled capacitor (13) and transistor (11) comprising the steps of;
forming a trench (18,20) in a substrate (10), said substrate having a first conductivity type;
forming a first doped region (22,24) in the surface of said trench, said doped region having a second conductivity type;
forming a first insulating layer (26) on the surface of said trench;
forming a conductive layer (28) over said substrate, on said first insulating layer and in said trench;
forming a mask (30) on said conductive layer;
etching said conductive layer using said mask as an etch mask, said etching extending through said conductive layer over the surface of said substrate, but not extending through said conductive layer over said trench, the region below where said etching extends through said conductive layer defining a moat area and the remaining portion of said conductive layer forming a field plate;
forming a second insulating layer (27, 32) on said field plate and said moat area;
forming a gate (40, 44) over said substrate in said moat area; and
implanting dopant ions into said substrate using said gate and said field plate as a mask to define source and drain regions (50) formed by said implanting;
characterised in that the step of forming the mask further comprises aligning the mask with the trench such that after etching the field plate does not cover the edge of the trench, such that the implanted source and drain regions make direct contact with said first doped region at the edge of the trench thereby electrically connecting the capacitor in the trench to the transistor in the moat area.

2. The method of claim 1, further comprising providing said substrate as crystalline silicon.

3. The method of claim 1 or claim 2, further comprising forming said first insulating layer of silicon dioxide by thermal oxidation.

4. The method of any preceding claim, further comprising forming said second insulating layer of silicon dioxide by thermal oxidation.

5. The method of any preceding claim, further comprising forming said conductive layer of polycrystalline silicon.

## Patentansprüche

1. Verfahren zum Herstellen eines gekoppelten Kondensators (13) und Transistors (11), enthaltend die Schritte:
Bilden eines Grabens (18, 20) in einem Substrat (10), wobei das Substrat einen ersten Leitungstyp hat;
Bilden einer ersten dotierten Zone (22, 24) in der Oberfläche des Grabens, wobei die dotierte Zone einen zweiten Leitungstyp hat;
Bilden einer ersten isolierenden Schicht (26) auf der Oberfläche des Grabens;
Bilden einer leitenden Schicht (28) über dem Substrat auf der ersten isolierenden Schicht und in dem Graben;
Bilden einer Maske (30) auf der leitenden Schicht;
Ätzen der leitenden Schicht unter Verwendung der Maske als Ätzmaske, wobei die Ätzung über der Oberfläche des Substrats durch die leitende Schicht hindurch, jedoch über dem Graben nicht durch die leitende Schicht hindurch verläuft, wobei die Zone, die dort darunter liegt, wo die Ätzung durch die leitende Schicht hindurchgeht, einen Vertiefungsbereich bildet, während der übrige Teil der leitenden Schicht eine Feldplatte bildet;
Bilden einer zweiten isolierenden Schicht (27, 32) auf der Feldplatte und dem Vertiefungsbereich;
Bilden einer Gate-Zone (40, 44) über dem Substrat in dem Vertiefungsbereich; und
Implantieren von Dotierungsionen in das Substrat unter Verwendung der Gate-Zone und der Feldplatte als Maske zum Festlegen von Source- und Drain-Zonen (50), die durch das Implantieren erzeugt werden;
dadurch gekennzeichnet, daß der Schritt des Bildens der Maske das derartige Ausrichten der Maske auf dem Graben umfaßt, daß nach dem Ätzen die Feldplatte den Rand des Grabens nicht überdeckt, so daß die implantierten Source- und Drain-Zonen direkt mit der ersten dotierten Zone am Rand des Grabens in Kontakt stehen, wodurch der Kondensator in dem Graben elektrisch mit dem Transistor in dem Vertiefungsbereich verbunden wird.

2. Verfahren nach Anspruch 1, ferner umfassend das Vorsehen des Substrats als kristallines Silizium.

3. Verfahren nach Anspruch 1 oder Anspruch 2, ferner umfassend das Bilden der ersten isolierenden Schicht aus Siliziumdioxid durch thermische Oxidation.

4. Verfahren nach einem vorhergehenden Anspruch, ferner enthaltend das Bilden der zweiten isolierenden Schicht aus Siliziumdioxid durch thermische Oxidation.

5. Verfahren nach einem vorhergehenden Anspruch, ferner umfassend das Bilden der leitenden Schicht aus polykristallinem Silizium.

## Revendications

1. Procédé de formation d'un condensateur (13) et d'un transistor (11) couplés comprenant les étapes suivantes:
formation d'une tranchée (18, 20) dans un substrat (10), ledit substrat ayant un premier type de conductivité;
formation d'une première région dopée (22, 24) dans la surface de ladite tranchée, ladite région dopée ayant un second type de conductivité;
formation d'une première couche isolante (26) sur la surface de ladite tranchée;
formation d'une couche conductrice sur ledit substrat (28), sur ladite première couche isolante, et dans ladite tranchée;
formation d'un masque (30) sur ladite couche conductrice;
attaque de ladite couche conductrice en utilisant ledit masque comme un masque d'attaque, ladite attaque traversant ladite couche conductrice sur la surface dudit substrat, mais ne traversant pas ladite couche conductrice sur ladite tranchée, la région au-dessous de laquelle ladite attaque traverse ladite couche conductrice définissant une zone de fossé et l'autre partie de ladite couche conductrice formant une plaque de champ;
formation d'une seconde couche isolante (27, 32) sur ladite plaque de champ et ladite zone de fossé;
formation d'une grille (40, 44) sur ledit substrat dans ladite zone de fossé; et
implantation d'ions dopants dans ledit substrat en utilisant ladite grille et ladite plaque de champ comme un masque pour définir des régions (50) de source et de drain formées par ladite implantation;
caractérisé en ce que l'étape de formation du masque comprend en outre l'alignement du masque avec la tranchée de manière qu'après l'attaque, la plaque de champ ne recouvre pas le bord de la tranchée de telle sorte que les régions implantées de source et de drain soient en contact direct avec ladite première région dopée au bord de la tranchée afin de connecter électriquement le condensateur dans la tranchée au transistor dans la zone de fossé.

2. Procédé selon la revendication 1, comprenant en outre la fourniture dudit substrat sous la forme de silicium cristallin.

3. Procédé selon la revendication 1 ou la revendication 2, comprenant en outre la formation de ladite première couche isolante de dioxyde de silicium par oxydation thermique.

4. Procédé selon l'une quelconque des revendications précédentes, comprenant en outre la formation de ladite seconde couche isolante de dioxyde de silicium par oxydation thermique.

5. Procédé selon l'une quelconque des revendications précédentes, comprenant en outre la formation de ladite couche conductrice de silicium polycristallin.
